(19) Europäisches Patentamt
European Patent Office
Office européen des brevets

(11) EP 2 211 294 A1

(12) **EUROPÄISCHE PATENTANMELDUNG**

(43) Veröffentlichungstag:
**28.07.2010 Patentblatt 2010/30**

(21) Anmeldenummer: **10161565.6**

(22) Anmeldetag: **09.06.2004**

(51) Int Cl.:
*G06K 15/12* (2006.01)   *B41J 2/45* (2006.01)
*H04N 1/06* (2006.01)   *B41B 19/00* (2006.01)
*B41J 19/16* (2006.01)

(84) Benannte Vertragsstaaten:
**DE FR GB IT NL**

(30) Priorität: **04.11.2003 DE 10351453**

(62) Dokumentnummer(n) der früheren Anmeldung(en)
nach Art. 76 EPÜ:
**04013561.8 / 1 530 151**

(71) Anmelder: **Heidelberger Druckmaschinen AG
69115 Heidelberg (DE)**

(72) Erfinder:
• **Ratjen, Hans-Jürgen
24576, Bad Bramstedt (DE)**
• **Schweger, Thies
25813, Husum (DE)**

Bemerkungen:
Diese Anmeldung ist am 30-04-2010 als
Teilanmeldung zu der unter INID-Code 62 erwähnten
Anmeldung eingereicht worden.

(54) **Verfahren zur Korrektur der Schrägaufzeichnung bei der Belichtung von Druckvorlagen**

(57) Die Erfindung betrifft ein Verfahren zur Korrektur der Schrägaufzeichnung einer Druckvorlage (15) auf einem Aufzeichnungsmaterial in einem Belichter, wobei ein Belichtungskopf (11) ein mit N Laserstrahlen (12) erzeugtes lineares Array von Belichtungspunkten (21) auf das Aufzeichnungsmaterial abbildet und der Belichtungskopf (11) kontinuierlich in einer axialen Vorschubrichtung an einer Belichtungstrommel (1) entlang bewegt wird, während die Belichtungstrommel (1) rotiert. Dadurch wird die Druckvorlage (15) entlang einer um die Belichtungstrommel (1) gewundenen Schraubenlinie aufgezeichnet. Die Laserstrahlen (12) werden mit Bilddaten moduliert, die aus einer gespeicherten Bildpunktmatrix (23) entlang eines gewinkelten Auslesepfads entnommen werden, wobei der Auslesepfad unter dem Winkel durch die Bildpunktmatrix (23) läuft, den die Schraubenlinie bezüglich einer Umfangslinie der Belichtungstrommel (1) bildet.

Fig. 4

EP 2 211 294 A1

**Beschreibung**

Die Erfindung bezieht sich auf das Gebiet der elektronischen Reproduktionstechnik und betrifft ein Verfahren zur Korrektur der Schrägaufzeichnung einer Druckvorlage auf einem Aufzeichnungsmaterial, insbesondere auf einer Druckplatte, in einem Belichter zur Aufzeichnung von Druckvorlagen.

In der Reproduktionstechnik werden Druckvorlagen für Druckseiten erzeugt, die alle zu druckenden Elemente wie Texte, Grafiken und Bilder enthalten. Für den farbigen Druck wird für jede Druckfarbe eine separate Druckvorlage erzeugt, die alle Elemente enthält, die in der jeweiligen Farbe gedruckt werden. Für den Vierfarbdruck sind das die Druckfarben Cyan, Magenta, Gelb und Schwarz (CMYK). Die nach Druckfarben separierten Druckvorlagen werden auch Farbauszüge genannt. Die Druckvorlagen werden in der Regel gerastert und mit einem Belichter auf Filme belichtet, mit denen dann Druckplatten für das Drucken hoher Auflagen hergestellt werden. Alternativ können die Druckvorlagen in speziellen Belichtungsgeräten auch gleich auf Druckplatten belichtet werden oder sie werden direkt als digitale Daten an eine digitale Druckmaschine übergeben. Dort werden die Druckvorlagendaten dann beispielsweise mit einer in die Druckmaschine integrierten Belichtungseinheit auf Druckplatten belichtet, bevor unmittelbar anschließend der Auflagendruck beginnt.

Nach dem heutigen Stand der Technik werden die Druckvorlagen elektronisch reproduziert. Dabei werden Bilder in einem Farbscanner gescannt und in Form von digitalen Daten gespeichert. Texte werden mit Textverarbeitungsprogrammen erzeugt und Grafiken mit Zeichenprogrammen. Mit einem Layoutprogramm werden die Bild-, Text- und Grafik-Elemente zu einer Druckseite zusammengestellt. Nach der Separation in die Druckfarben liegen die Druckvorlagen dann in digitaler Form vor. Als Datenformate zur Beschreibung der Druckvorlagen werden heute weitgehend die Seitenbeschreibungssprachen Postscript und PDF (Portable Document Format) verwendet. Die Postscript- bzw. PDF-Daten werden vor der Aufzeichnung der Druckvorlagen in einem Raster-Image-Prozessor (RIP) in einem ersten Schritt in Farbauszugswerte für die Farbauszüge CMYK umgerechnet. Dabei entstehen für jeden Bildpunkt vier Farbauszugswerte als Tonwerte im Wertebereich von 0 bis 100%. Die Farbauszugswerte sind ein Maß für die Farbdichten, mit denen die vier Druckfarben Cyan, Magenta, Gelb und Schwarz auf dem Bedruckstoff gedruckt werden. In Sonderfällen, in denen mit mehr als vier Farben gedruckt wird (Schmuckfarben), ist jeder Bildpunkt durch so viele Farbauszugswerte beschrieben, wie es Druckfarben gibt. Die Farbauszugswerte können z.B. mit 8 bit je Bildpunkt und Druckfarbe als Datenwerte gespeichert sein, womit der Wertebereich von 0 % bis 100% in 256 Tonwertstufen unterteilt ist.

Die Daten mehrerer Druckseiten werden mit den Daten weiterer Elemente, wie Passkreuzen, Schnittmarken und Falzmarken sowie Druckkontrollfeldern, zu Druckvorlagen für einen Druckbogen zusammengefasst. Diese Druckbogendaten werden ebenfalls als Farbauszugswerte (CMYK) bereit gestellt.

Unterschiedliche Tonwerte eines zu reproduzierenden Farbauszugs lassen sich im Druck nur durch eine Flächenmodulation der aufgetragenen Druckfarben, d.h. durch eine Rasterung, wiedergeben. Die Flächenmodulation der Druckfarben kann beispielsweise nach einem Verfahren zur Punktrasterung erfolgen, bei dem die verschiedenen Tonwertstufen der Farbauszugsdaten in Rasterpunkte unterschiedlicher Größe umgewandelt werden, die in einem regelmäßigen Raster mit sich periodisch wiederholenden Rasterzellen angeordnet sind. Bei der Aufzeichnung der Farbauszüge auf eine Druckplatte werden die Rasterpunkte in den einzelnen Rasterzellen aus Belichtungspunkten zusammengesetzt, die um eine Größenordnung kleiner als die Rasterpunkte sind. Eine typische Auflösung der Belichtungspunkte ist beispielsweise 1000 Belichtungspunkte je Zentimeter, d.h. ein Belichtungspunkt hat die Abmessungen 10 $\mu$m $\times$ 10 $\mu$m. Die Umsetzung der Farbauszugswerte in Rasterpunkte geschieht in einem zweiten Schritt bei der weiteren Verarbeitung der Farbauszugsdaten im Raster-Image-Prozessor, wodurch die Farbauszugsdaten in hochaufgelöste Binärwerte mit nur zwei Helligkeitswerten (belichtet bzw. nicht belichtet) umgewandelt werden, die das Muster des modulierten Punktrasters bilden. Auf diese Weise werden die Druckvorlagendaten jedes Farbauszugs in Form einer hochaufgelösten Rasterbitmap beschrieben, die für jeden der Belichtungspunkte auf der Druckfläche ein Bit enthält, das angibt, ob dieser Belichtungspunkt zu belichten ist oder nicht.

In den Aufzeichnungsgeräten, die in der elektronischen Reproduktionstechnik zur Belichtung von Druckvorlagen und Druckformen eingesetzt werden, wird beispielsweise ein Laserstrahl von einer Laserdiode erzeugt, durch optische Mittel geformt und auf das Aufzeichnungsmaterial fokussiert und mittels eines Ablenksystems Punkt- und Linienweise über das Aufzeichnungsmaterial abgelenkt. Es gibt auch Aufzeichnungsgeräte, die zur Erhöhung der Belichtungsgeschwindigkeit ein Bündel von Laserstrahlen erzeugen, z.B. mit einer separaten Laserlichtquelle für jeden Laserstrahl, und mit jedem Überstreichen des Aufzeichnungsmaterials mehrere Aufzeichnungslinien der Druckform gleichzeitig belichten. Die Druckformen können auf Filmmaterial belichtet werden, so dass sogenannte Farbauszugsfilme entstehen, die anschließend mittels eines fotografischen Umkopierverfahrens zur Herstellung von Druckplatten dienen. Statt dessen können auch die Druckplatten selbst in einem Plattenbelichter oder direkt in einer digitalen Druckmaschine belichtet werden, in die eine Einheit zur Plattenbelichtung integriert ist. Das Aufzeichnungsmaterial kann sich auf einer ebenen Fläche befinden (Flachbettbelichter), in einer zylindrischen Mulde (Innentrommelbelichter) oder auf einer Trommel (Außentrommelbelichter).

Flachbettbelichter arbeiten überwiegend mit einem schnell rotierenden Polygonspiegel, dessen Spiegelflächen den Laserstrahl quer über das Aufzeichnungsmaterial lenken, während gleichzeitig das Aufzeichnungsmaterial senkrecht zur Ablenkrichtung des Laserstrahls bewegt wird. Auf diese Weise wird Aufzeichnungslinie für Aufzeichnungslinie belichtet. Da sich bei der Bewegung des Laserstrahls über das Aufzeichnungsmaterial die Länge des Lichtwegs ändert, ist eine aufwendige Abbildungsoptik erforderlich, die die dadurch bedingte Größenänderungen des Belichtungspunktes kompensiert.

Bei einem Innentrommelbelichter wird das zu belichtende Material auf der Innenfläche eines teilweise offenen Hohlzylinders montiert und mit einem Laserstrahl belichtet, der entlang der Zylinderachse auf eine Ablenkvorrichtung gerichtet wird, die den Laserstrahl senkrecht auf das Material reflektiert. Die Ablenkvorrichtung, ein Prisma oder ein Spiegel, rotiert im Betrieb mit hoher Drehzahl und wird dabei in Richtung der Zylinderachse bewegt, so dass der abgelenkte Laserstrahl kreisförmige oder schraubenförmige Aufzeichnungslinien auf dem Material beschreibt.

Bei einem Außentrommelbelichter wird das zu belichtende Material in Form von Filmen oder Druckplatten auf eine drehbar gelagerte Trommel montiert. Während die Trommel rotiert, wird ein Belichtungskopf in einem relativ kurzen Abstand axial an der Trommel entlang bewegt. Der Belichtungskopf fokussiert einen oder mehrere Laserstrahlen auf die Trommeloberfläche, die die Trommeloberfläche in Form von Schraubenlinien überstreichen. Auf diese Weise werden bei jeder Trommelumdrehung eine bzw. mehrere Aufzeichnungslinien auf das Aufzeichnungsmaterial belichtet.

Um die Belichtungszeit zu verkürzen und damit die Wirtschaftlichkeit des Belichters zu erhöhen, arbeiten Außentrommelbelichter bevorzugt mit einem Bündel von N Laserstrahlen, die mittels einer Belichtungsoptik als ein in Achsrichtung der Belichtungstrommel orientiertes lineares Array von Belichtungspunkten auf der Oberfläche des Aufzeichnungsmaterials abgebildet werden. Die Zahl der Laserstrahlen beträgt beispielsweise N=64, kann aber auch ein Mehrfaches davon sein. Wenn die Belichtungstrommel rotiert, werden dann N Aufzeichnungslinien parallel belichtet, die sich schraubenförmig um die Oberfläche der Belichtungstrommel winden. Die Vorschubgeschwindigkeit des Belichtungskopfes ist so eingestellt, dass er sich nach einer Trommelumdrehung um eine Strecke in Achsrichtung der Trommel bewegt hat, die der Breite der N Aufzeichnungslinien entspricht. Dadurch schließen sich die bei der nächsten Trommelumdrehung zu belichtenden N Aufzeichnungslinien unmittelbar an die bei der vorangegangenen Trommelumdrehung belichteten N Aufzeichnungslinien an. Bei einer anderen Arbeitsweise, dem sogenannten Interleave-Schreibverfahren, werden die Laserstrahlen nicht als N Belichtungspunkte mit dem Abstand von jeweils einer Aufzeichnungslinienbreite abgebildet sondern mit einem größeren Abstand, der der Breite von mehreren Aufzeichnungslinien entspricht. Die Vorschubgeschwindigkeit des Belichtungskopfes wird dann so eingestellt, dass bei aufeinanderfolgenden Trommelumdrehungen nach und nach die Lücken zwischen den zunächst belichteten Aufzeichnungslinien mit weiteren Aufzeichnungslinien gefüllt werden. In allen Fällen ist die Vorschubstrecke je Trommelumdrehung jedoch so groß, dass die Aufzeichnungslinien entsprechend der Schraubenlinie merkbar schräg aufgezeichnet werden. Dadurch werden die Druckvorlagendaten in Form der rechteckigen Rasterbitmap zu einem Parallelogramm verzerrt.

Es sind verschiedene Verfahren bekannt, mit denen die Schrägaufzeichnung der Druckvorlagendaten in einem Außentrommelbelichter kompensiert wird. In der US 4591880 wird ein Verfahren beschrieben, bei dem der Startpunkt der Aufzeichnungslinien von Umdrehung zu Umdrehung etwas vorverlegt wird, so dass eine rechteckige Matrix von Bildpunkten aufgezeichnet wird, die aber insgesamt mit Bezug auf die Kanten des Aufzeichnungsmaterials um den Winkel der Schrägaufzeichnung gedreht ist.

Bei dem in der EP 1318660 A2 offenbarten Verfahren wird zusätzlich zum Versetzen des Startpunkts der Aufzeichnungslinien von Umdrehung zu Umdrehung das Aufzeichnungsmaterial schief auf die Belichtungstrommel gespannt, um den Winkel der Schrägaufzeichnung auszugleichen, so dass die Bildpunktmatrix rechteckig und parallel zu den Kanten des Aufzeichnungsmaterials belichtet wird.

Nach dem in der GB 2129650 A beschriebenen Verfahren erfolgt die Korrektur der Schrägaufzeichnung, indem der Belichtungskopf an der Belichtungstrommel entlang einer Linie bewegt wird, die um den Winkel der Schrägaufzeichnung gegen die Trommelachse geneigt ist.

In der EP 0918255 A2 wird ein Verfahren beschrieben, mit dem die Druckvorlagendaten vorverzerrt werden, um die Schrägaufzeichnung zu kompensieren. Dazu werden die Druckvorlagendaten gegenläufig zum Winkel der Schrägaufzeichnung in einem Pufferspeicher verschoben, so dass die Bildpunktmatrix zu einem gegenläufig geneigten Parallelogramm verformt wird. Durch die anschließende Schrägaufzeichnung wird diese Vorverzerrung wieder aufgehoben, und die Bildpunktmatrix wird rechteckig aufgezeichnet.

Es ist die Aufgabe der vorliegenden Erfindung, ein alternatives und einfaches Verfahren zur Korrektur der Schrägaufzeichnung in einem Außentrommelbelichter anzugeben, der eine Druckvorlage mit N Laserstrahlen belichtet, wobei mit jeder Trommelumdrehung jeweils N Aufzeichnungslinien gleichzeitig belichtet werden. Die Korrektur erfolgt, indem bei der Aufzeichnung die Druckvorlagendaten aus einem Speicher für die Bildpunktmatrix entlang eines Pfads ausgelesen werden, der in Richtung der Schrägaufzeichnung um den Winkel der Schrägaufzeichnung geneigt ist. Auf diese Weise wird die Bildpunktmatrix unverzerrt aufgezeichnet, ohne dass die Bildpunktmatrix vorverzerrt werden muss oder Bilddaten im Speicher verschoben werden müssen.

Die Erfindung wird anhand der Figuren näher beschrieben.

Es zeigen:

Fig. 1      den Aufbau eines Außentrommelbelichters,

Fig. 2a      die Schrägaufzeichnung einer Druckvorlage auf einer abgewickelten Trommeloberfläche,

Fig. 2b      eine Speicherorganisation für eine Bildpunktmatrix,

Fig. 3      die Relation zwischen Gruppen von Bildlinien und Aufzeichnungslinien,

Fig. 4      den Aufbau einer Aufzeichnungslinie aus Abschnitten von Bildlinien, und

Fig. 5      eine weitere Ausführungsform für den Aufbau einer Aufzeichnungslinie.

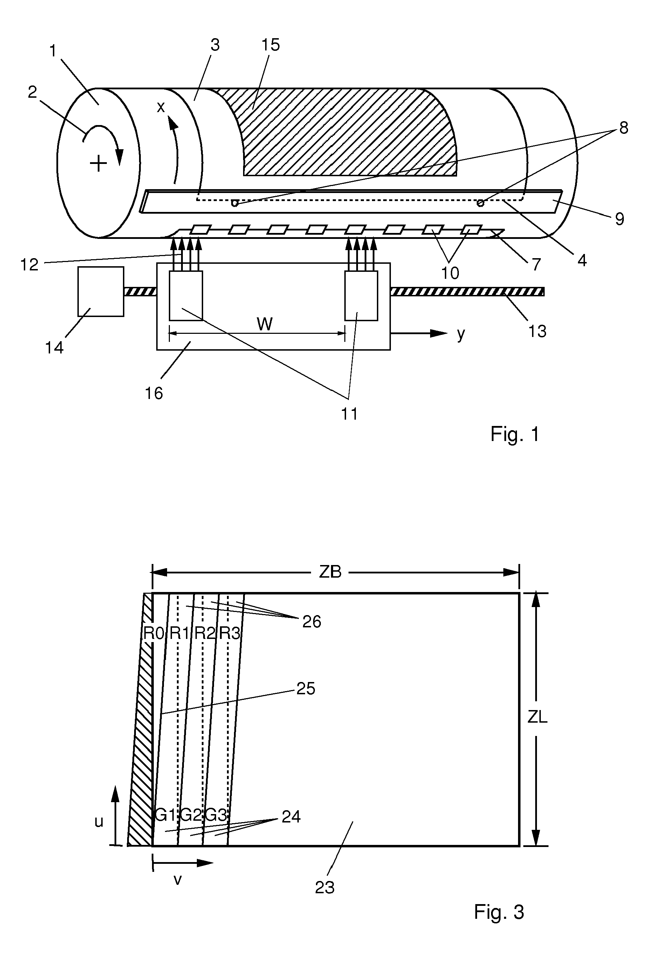

Fig. 1 zeigt schematisch den Aufbau eines Außentrommelbelichters zur Belichtung einer Druckvorlage 15 auf eine Druckplatte 3. Eine Belichtungstrommel 1 ist drehbar gelagert und kann mit einem nicht gezeigten Rotationsantrieb in Richtung des Rotationspfeils 2 in eine gleichmäßige Rotationsbewegung versetzt werden. Auf die Belichtungstrommel 1 ist eine unbelichtete Druckplatte 3 gespannt. Die Druckplatte 3 wird so aufgespannt, dass ihre Vorderkante 4 Anlagestifte 8 berührt, die mit der Belichtungstrommel 1 fest verbunden sind und über die Oberfläche der Belichtungstrommel 1 hinausragen. Eine Klemmleiste 9 drückt die Vorderkante 4 außerdem fest auf die Oberfläche der Belichtungstrommel 1 und fixiert dadurch die Vorderkante 4 der Druckplatte 3. Die Druckplatte 3 wird flächig mittels einer in Fig. 1 nicht gezeigten Vakuumeinrichtung, die die Druckplatte 3 durch Löcher in der Trommeloberfläche ansaugt, auf der Trommeloberfläche gehalten, damit die Druckplatte 3 nicht durch die Fliehkräfte bei der Rotation der Belichtungstrommel 1 abgelöst wird. Zusätzlich wird die Hinterkante 7 der Druckplatte 3 mit Klemmstücken 10 am Abheben von der Belichtungstrommel 1 gehindert.

Ein Belichtungskopf 11 oder auch mehrere Belichtungsköpfe 11, die auf einem gemeinsamen Belichtungskopfträger 16 angeordnet sind, werden in einem relativ kurzen Abstand axial an der Belichtungstrommel 1 entlang bewegt, während die Belichtungstrommel 1 rotiert. Jeder Belichtungskopf 11 fokussiert ein Bündel von N Laserstrahlen 12 auf die Trommeloberfläche, die die Trommeloberfläche in Form von Schraubenlinien überstreichen. Auf diese Weise werden bei jeder Trommelumdrehung eine bzw. mehrere Gruppen von N Aufzeichnungslinien in der Umfangsrichtung x auf das Aufzeichnungsmaterial belichtet. Der Belichtungskopfträger 16 wird in der Vorschubrichtung y mittels einer Vorschubspindel 13 bewegt, mit der er formschlüssig verbunden ist und die mit einem Vorschubantrieb 14 in Drehbewegung versetzt wird.

Durch die Verwendung mehrerer Belichtungsköpfe 11 wird die Produktivität des Belichters erhöht, insbesondere für die Belichtung von großformatigen Druckplatten 3, da eine Druckplatte 3 in kürzerer Zeit belichtet werden kann. Fig. 1 zeigt als Beispiel einen Belichter mit zwei Belichtungsköpfen 11, die in axialer Richtung im Abstand W angeordnet sind und jeweils ein Bündel von N Laserstrahlen 12 auf die Druckplatte 3 fokussieren. Die Druckplatte 3 wird dadurch gleichzeitig mit zwei Gruppen von Aufzeichnungslinien belichtet, die im axialen Abstand W die Trommeloberfläche überstreichen. Nachdem die Belichtungsköpfe 11 die Vorschubstrecke W zurückgelegt haben, ist die Belichtung der Druckplatte 3 abgeschlossen.

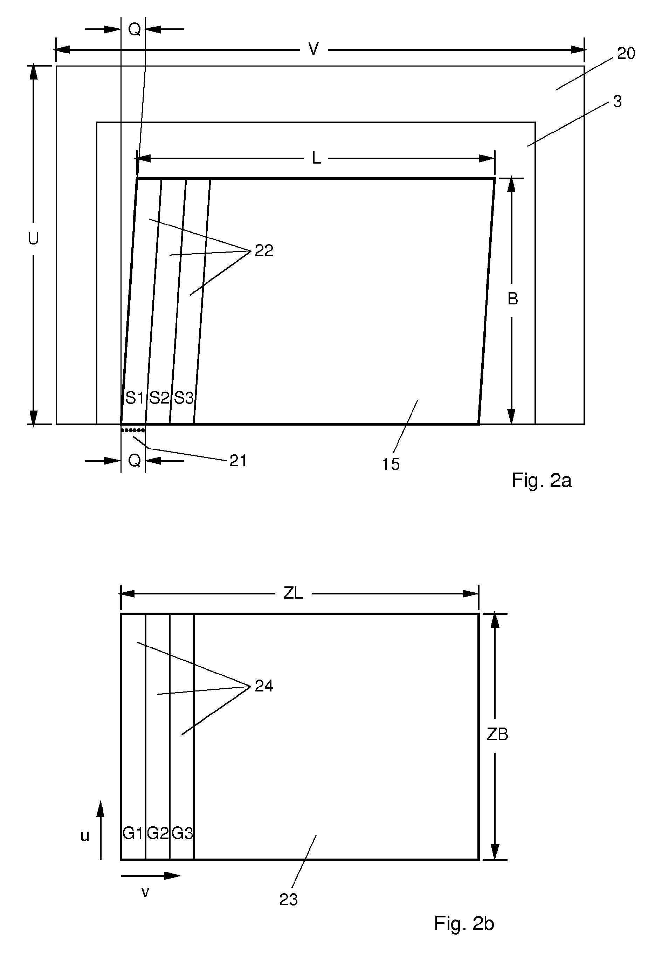

Fig. 2a veranschaulicht die Schrägaufzeichnung, die sich bei der Belichtung mit jeweils N Laserstrahlen ergibt. Fig. 2a zeigt die abgewickelte Trommeloberfläche 20 mit den Abmessungen U in Umfangsrichtung und V in Vorschubrichtung. Auf die Trommeloberfläche 20 ist die Druckplatte 3 aufgespannt, auf der die Druckvorlage 15 mit den Abmessungen B in Umfangsrichtung und L in Vorschubrichtung aufgezeichnet wird. Die Aufzeichnung erfolgt jeweils parallel mit N Laserstrahlen 12, die als ein in Vorschubrichtung orientiertes lineares Array von Belichtungspunkten 21 abgebildet werden. Die Zahl der Belichtungspunkte 21 in dem Array beträgt beispielsweise N=64. Wenn die Belichtungstrommel rotiert, werden Bildstreifen 22 von jeweils N parallelen Aufzeichnungslinien belichtet, die in Fig. 2a mit S1, S2, S3, usw. bezeichnet sind. Mit der Auflösung A, beispielsweise A = 100 Bildpunkte/mm, beträgt die Streifenbreite Q in mm:

$$Q = N / A \qquad\qquad\qquad (1)$$

Die Vorschubgeschwindigkeit des Belichtungskopfes ist so eingestellt, dass er sich nach einer Trommelumdrehung um die Strecke Q in Vorschubrichtung bewegt hat, so dass sich die bei jeder Trommelumdrehung belichteten Bildstreifen 22 nahtlos aneinander anschließen.

Fig. 2b zeigt eine Speicherorganisation für die zu belichtende Bildpunktmatrix 23. Der Speicher ist zweidimensional organisiert, mit der Dimensionsrichtung u, die der Umfangsrichtung auf der Belichtungstrommel entspricht und der Dimensionsrichtung v, die der Vorschubrichtung auf der Belichtungstrommel entspricht. Die Bildpunktmatrix 23 hat ZB Bildpunkte in Umfangsrichtung u, d.h. jede Bildlinie umfasst ZB Bildpunkte, und die Bildpunktmatrix 23 hat ZL Bildlinien in Vorschubrichtung v. Die Zahl ZB der Bildpunkte je Bildlinie und die Zahl ZL der Bildlinien ergeben sich aus den Abmessungen der Druckvorlage 15 und aus der Auflösung zu:

$$ZB = B \times A$$

$$ZL = L \times A \qquad\qquad (2)$$

Den Bildstreifen 22 von jeweils N parallel belichteten Bildlinien entsprechen in der Bildpunktmatrix 23 Bildliniengruppen 24, die in Fig. 2b mit G1, G2, G3, usw. bezeichnet sind. Jede Bildliniengruppe 24 umfasst die Bilddaten von N Aufzeichnungslinien, die als ein Bildstreifen 22 belichtet werden. Weil die Aufzeichnungslinien entsprechend der Schraubenlinie um die Belichtungstrommel 1 schräg aufgezeichnet werden, resultiert daraus eine Parallelogrammverzerrung der Bildpunktmatrix 23 auf der aufgezeichneten Druckvorlage 15.

Nach dem erfindungsgemäßen Verfahren werden die Bilddaten aus dem Speicher der Bildpunktmatrix 23 auf schräg liegenden Auslesepfaden ausgelesen, deren Winkel dem Winkel der Schrägaufzeichnung auf der Belichtungstrommel 1 entspricht. Dies ist in Fig. 3 dargestellt. Entlang eines schräg liegenden Auslesepfads wird aus der gespeicherten Bildpunktmatrix 23 jeweils eine Aufzeichnungslinie 25 von Bilddaten zusammengestellt, die abschnittsweise aus verschiedenen Bildlinien der Bildpunktmatrix entnommen werden. Jeweils N parallele Aufzeichnungslinien 25 bilden eine Aufzeichnungsliniengruppe 26. Die Aufzeichnungsliniengruppen 26 sind in Fig. 3 mit R0, R1, R2, R3 usw. bezeichnet, die Bildliniengruppen 24 sind gestrichelt eingezeichnet. Jede Aufzeichnungsliniengruppe 26 wird als ein entsprechender Bildstreifen 22 belichtet.

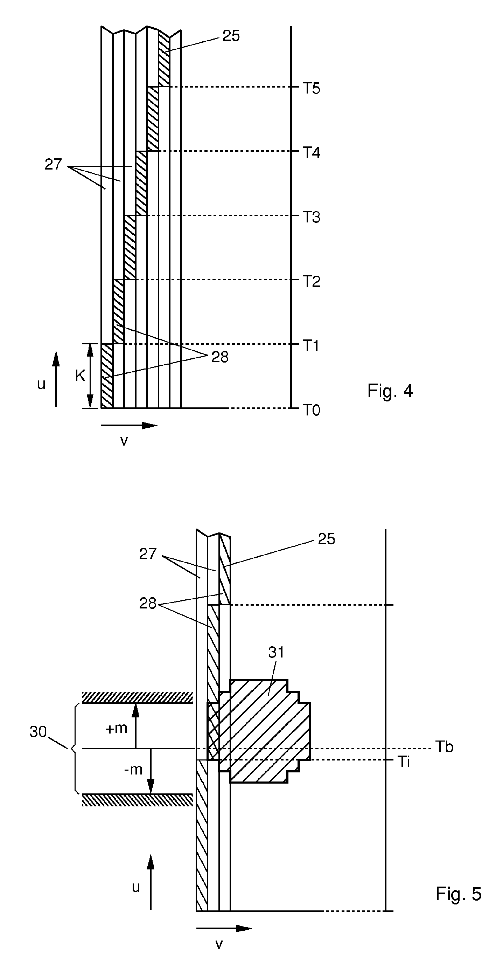

Fig. 4 zeigt einen Ausschnitt aus der Bildpunktmatrix 23 mit einzelnen Bildlinien 27 und den Aufbau einer Aufzeichnungslinie 25 aus Linienabschnitten 28. Die Aufzeichnungslinie 25 wird aus Linienabschnitten 28 zusammengesetzt, die jeweils K Bildpunkte lang sind. Nachdem für die ersten K Bildpunkte der Aufzeichnungslinie 25 ein erster Linienabschnitt 28 aus den Bildpunkten 0...K-1 einer ersten Bildlinie 27 der Bildpunktmatrix 23 entnommen ist, wird für die nächsten K Bildpunkte der Aufzeichnungslinie 25 ein zweiter Linienabschnitt 28 aus den Bildpunkten K...2K-1 der Bildlinie entnommen, die der ersten Bildlinie in Vorschubrichtung v benachbart ist, usw. Die Zahl der Bildpunkte K je Linienabschnitt 28 wird so bestimmt, dass N Linienabschnitte 28 zusammen die Zahl der Bildpunkte ergeben, die dem Umfang U der Trommeloberfläche 20 entspricht, d.h. es gilt:

$$K = (U \times A) / N \qquad\qquad (3)$$

Bei der Bestimmung des Umfangs U wird die Dicke der Druckplatte 3 berücksichtigt, d.h. der Umfang U wird aus dem Radius der Belichtungstrommel 1 plus der Dicke der Druckplatte 3 berechnet. Da der nach Gleichung (3) bestimmte Wert für K im allgemeinen keine ganze Zahl ist, wird der Bildpunkt, bei dem die Aufzeichnungslinie 25 auf die nächste Bildlinie 27 wechselt, durch Rundung auf die nächste ganze Zahl bestimmt, d.h. für den Bildpunkt Ti, bei dem der i-te Linienabschnitt 28 beginnt, gilt:

$$Ti = [i \times K]_1 \qquad (i = 0, 1, 2, ....) \qquad\qquad (4)$$

In der Gleichung (4) bedeutet der Index 1 der eckigen Klammer eine Rundung auf die nächste ganze Zahl. Sowohl die Zählung der Bildpunkte als auch die Zählung der Linienabschnitte beginnt bei Null. In der Fig. 4 sind die Wechselpunkte Ti auf einer Skala markiert. Zweckmäßigerweise wird der Wechsel auf den nächsten Linienabschnitt 28 für alle Aufzeichnungslinien 25 einer Aufzeichnungsliniengruppe 26 bei jeweils den gleichen Wechselpunkten Ti vorgenommen.

Die Zusammenstellung der Aufzeichnungslinien 25 aus den Linienabschnitten 28 der Bildlinien 27 in der Bildpunktmatrix 23 wird bevorzugt mittels eines Computerprogramms durchgeführt. Dazu wird beispielsweise in einem Speicherbereich eine ausreichend große Anzahl von Bildlinien 27 der Bildpunktmatrix 23 bereitgestellt. In einem zweiten Speicherbereich werden die Aufzeichnungslinien 25 für eine Aufzeichnungsliniengruppe 26 zwischengespeichert, indem die entsprechenden Linienabschnitte 28, aus denen die Aufzeichnungslinien 25 gebildet werden, vom ersten Speicherbereich in den zweiten Speicherbereich umkopiert werden. Für die Zusammenstellung der nächsten Aufzeichnungsliniengruppen 26 werden die dafür jeweils benötigten Bildlinien 27 aus der Bildpunktmatrix 23 in den ersten Speicherbereich nachgeladen, wobei die gesamte Bildpunktmatrix 23 beispielsweise auf einer Festplatte gespeichert ist. Beim Umkopieren kann auch eine Drehung der Aufzeichnungsdaten um 90 Grad durchgeführt werden, wobei die Bildpunkte so umsortiert werden, dass jeweils die Bildpunkte dicht gepackt werden, die zur Ansteuerung des Arrays von Belichtungspunkten 21 für jede Belichtungsposition in Umfangsrichtung der Belichtungstrommel 1 gleichzeitig benötigt werden. Damit keine Bilddaten aus der Bildpunktmatrix 23 bei der Aufzeichnung verloren gehen, wird die erste Aufzeichnungsliniengruppe 26 (R0 in Fig. 3) in Vorschubrichtung so positioniert, dass sie vor der Bildpunktmatrix 23 beginnt. Der in Fig. 3 schraffierte Teil der Aufzeichnungslinien 25 wird dabei mit Nulldaten gefüllt, d.h. mit Bilddaten, die zu keiner Belichtung des Aufzeichnungsmaterials führen. Die so zusammengestellten Aufzeichnungsdaten werden entweder gleich dem Belichtungskopf 11 zur direkten Belichtung des Aufzeichnungsmaterials zugeführt, oder sie werden auf einer Festplatte zwischengespeichert, um die Belichtung zu einem späteren Zeitpunkt durchzuführen.

Da die Bildpunktmatrix wie zuvor erläutert eine Rasterbitmap ist, d.h. jeder Bildpunkt ein Bit groß ist, sind in dem Speicher mit einer Wortlänge von beispielsweise 32 Bit zweckmäßigerweise jeweils 32 Bildpunkte in einem Speicherwort enthalten. Insbesondere bei der Implementierung des Verfahrens mittels eines Computerprogramms wäre es daher umständlich und aufwändig, den Wechsel zum nächsten Linienabschnitt 28 bei einem Bildpunkt Ti vorzunehmen, der mitten in einem Speicherwort liegt. Bei einer bevorzugten Ausführungsform des erfindungsgemäßen Verfahrens ist deshalb vorgesehen, den Wechsel von einem Linienabschnitt 28 zum nächsten nur an einer Speicherwortgrenze durchzuführen. In diesem Fall wird der Bildpunkt Ti, bei dem der i-te Linienabschnitt 28 beginnt, bestimmt als:

$$Ti = [i \times K]_{32} \qquad (i = 0, 1, 2, ....) \qquad\qquad (5)$$

In der Gleichung (5) bedeutet der Index 32 der eckigen Klammer eine Rundung auf die nächste ganzzahlig durch 32 teilbare Zahl.

Fig. 5 zeigt eine weitere Ausführungsform des erfindungsgemäßen Verfahrens, bei der der aktuelle Wechselpunkt Ti für den Übergang von einem Linienabschnitt 28 zum nächsten abhängig vom Bildinhalt bestimmt wird. Dazu wird um den nach Gleichung (4) berechneten Wechselpunkt Tb herum ein Prüfbereich 30 gebildet, der in Umfangsrichtung u von -m Bildpunkten vor dem berechneten Wechselpunkt Tb bis zu +m Bildpunkten nach dem berechneten Wechselpunkt Tb reicht. Die Zahl m wird auf der Basis eines Erfahrungswertes festgelegt, der mittels Belichtungsversuchen ermittelt werden kann und der eine gute Bildqualität der aufgezeichneten Druckvorlage 15 gewährleistet. Ein geeigneter Wert ist beispielsweise m = 8, bei dem der Prüfbereich etwa so groß ist wie die Rasterweite, d.h. wie eine Seitenlänge der Rasterzelle, die der Rasterung der Druckvorlage 15 zugrunde liegt. Dann wird geprüft, ob innerhalb des Prüfbereichs 30 auf der aktuellen Bildlinie 27 oder auf der folgenden Bildlinie, auf die gewechselt werden soll, in den Bilddaten ein Farbsprung von Weiß nach Schwarz bzw. von Schwarz nach Weiß auftritt. Wenn innerhalb des Prüfbereichs 30 kein Farbsprung vorhanden ist, erfolgt der Wechsel zum nächsten Linienabschnitt 28 am berechneten Wechselpunkt Tb. Wenn innerhalb des Prüfbereichs 30 genau ein Farbsprung vorhanden ist, entweder in der aktuellen Bildlinie 27 oder in der folgenden Bildlinie, wird der aktuelle Wechselpunkt Ti zu der Stelle des Farbsprungs hin verschoben. In Fig. 5 ist ein Rasterpunkt 31 eingezeichnet, der einen Farbsprung in der Bildlinie 27 bewirkt, aus der der nächste Linienabschnitt 28 entnommen werden soll. Wenn innerhalb des Prüfbereichs 30 mehr als ein Farbsprung vorhanden ist, in der aktuellen Bildlinie 27 und/oder in der folgenden Bildlinie, wird der aktuelle Wechselpunkt Ti beispielsweise zu dem Farbsprung hin verschoben, der dem berechneten Wechselpunkt Tb in Umfangsrichtung u am nächsten liegt. In diesem Fall kann die Verschiebung des aktuellen Wechselpunkts Ti auch nach einer anderen Regel erfolgen, zum Beispiel nach einer Zufallsauswahl zu einem der Farbsprünge innerhalb des Prüfbereichs 30.

Der vom Bildinhalt gesteuerte Wechsel von einem Linienabschnitt 28 zum nächsten kann so erfolgen, dass die Untersuchung des Prüfbereichs 30 und die Entscheidung, wohin der aktuelle Wechselpunkt Ti gelegt wird, für jede Aufzeichnungslinie 25 separat durchgeführt wird. In einer vereinfachten Form kann die Prüfung und Entscheidung aber auch für eine Aufzeichnungslinie 25 aus einer Anzahl von p benachbarten Aufzeichnungslinien durchgeführt werden, und die Entscheidung über die Lage des Wechselpunkts Ti dann in die folgenden p-1 Aufzeichnungslinien übernommen werden. In einem Sonderfall ist p = N, d.h. die Prüfung und Entscheidung wird nur für eine Aufzeichnungslinie 25 aus einer Aufzeichnungsliniengruppe 26 durchgeführt.

Obwohl das erfindungsgemäße Verfahren für den Fall beschrieben wurde, dass die Aufzeichnungslinien 25 unmittelbar nebeneinander belichtet werden, d.h. mit einem Abstand zwischen den Aufzeichnungslinien, der der Auflösung A entspricht, kann das Verfahren jedoch auch für das sogenannte Interleave-Schreibverfahren angewendet werden. Beim Interleave-Schreibverfahren haben die Aufzeichnungslinien 25 einen größeren Abstand als es der Auflösung A entspricht. Bei bestimmten Kombinationen von Linienzahl N und Linienabstand werden in aufeinanderfolgenden Trommelumdrehungen nach und nach die Lücken zwischen den zunächst belichteten Aufzeichnungslinien 25 mit weiteren Aufzeichnungslinien gefüllt, so dass schließlich doch eine lückenlose Belichtung des Aufzeichnungsmaterials erfolgt.

**Bezugszeichenliste**

1 Belichtungstrommel
2 Rotationspfeil
3 Druckplatte
4 Vorderkante
7 Hinterkante
8 Anlagestift
9 Klemmleiste
10 Klemmstück
11 Belichtungskopf
12 Laserstrahl
13 Vorschubspindel
14 Vorschubantrieb
15 Druckvorlage
16 Belichtungskopfträger
20 Trommeloberfläche
21 Array von Belichtungspunkten
22 Bildstreifen
23 Bildpunktmatrix
24 Bildliniengruppe
25 Aufzeichnungslinie
26 Aufzeichnungsliniengruppe
27 Bildlinie
28 Linienabschnitt
30 Prüfbereich
31 Rasterpunkt

**Patentansprüche**

1. Verfahren zur Korrektur der Schrägaufzeichnung einer Druckvorlage (15) auf einem Aufzeichnungsmaterial in einem Belichter, wobei

- das Aufzeichnungsmaterial auf eine Belichtungstrommel (1) gespannt wird,
- ein Belichtungskopf (11) N Laserstrahlen (12) erzeugt, die als ein in Vorschubrichtung orientiertes lineares Array von Belichtungspunkten (21) auf das Aufzeichnungsmaterial abgebildet werden,
- der Belichtungskopf (11) kontinuierlich in einer axialen Vorschubrichtung an der Belichtungstrommel (1) entlang bewegt wird, während die Belichtungstrommel (1) rotiert, wodurch die Druckvorlage (15) entlang einer um die Belichtungstrommel (1) gewundenen Schraubenlinie aufgezeichnet wird,
- die Laserstrahlen (12) mit Bilddaten moduliert werden, die aus einer in Bildlinien (27) organisierten gespeicherten Bildpunktmatrix (23) entnommen werden, und
- die Druckvorlage (15) mit einer Belichtungsauflösung von A Bildpunkten je Längeneinheit aufgezeichnet wird, **dadurch gekennzeichnet, dass**
- Aufzeichnungslinien (25) aus Bilddaten gebildet werden, die entlang eines gewinkelten Auslesepfads aus der Bildpunktmatrix (23) entnommen werden, und
- die Laserstrahlen (12) mit den Bilddaten der Aufzeichnungslinien (25) moduliert werden.

2. Verfahren nach Anspruch 1, **dadurch gekennzeichnet, dass** der Auslesepfad unter dem Winkel durch die Bildpunktmatrix (23) läuft, den die Schraubenlinie bezüglich einer Umfangslinie der Belichtungstrommel (1) bildet.

3. Verfahren nach Anspruch 1, **dadurch gekennzeichnet, dass** die Aufzeichnungslinien (25) aus Linienabschnitten (28) zusammengesetzt werden, die aus benachbarten Bildlinien (27) entnommen werden.

4. Verfahren nach Anspruch 3, **dadurch gekennzeichnet, dass** die Zahl der Bildpunkte K je Linienabschnitt (28) nach der Beziehung

$$K = (U \times A) / N$$

bestimmt wird, wobei U der Umfang der Belichtungstrommel (1) ist.

5. Verfahren nach einem der Ansprüche 3 oder 4, **dadurch gekennzeichnet, dass** ein Wechselpunkt Ti, bei dem der nächste Linienabschnitt (28) in der nächsten Bildlinie (27) beginnt, nach der Beziehung

$$Ti = [i \times K]_1 \qquad (i = 0, 1, 2, ....)$$

bestimmt wird, wobei das Produkt in der eckigen Klammer auf die nächste ganze Zahl gerundet wird.

6. Verfahren nach einem der Ansprüche 3 oder 4, **dadurch gekennzeichnet, dass** ein Wechselpunkt Ti, bei dem der nächste Linienabschnitt (28) in der nächsten Bildlinie (27) beginnt, nach der Beziehung

$$Ti = [i \times K]_{WL} \qquad (i = 0, 1, 2, ....)$$

bestimmt wird, wobei das Produkt in der eckigen Klammer auf die nächste ganzzahlig durch WL teilbare Zahl gerundet wird und WL die Wortlänge des Speichers in Bit ist, in dem die Bildpunktmatrix (23) gespeichert ist.

7. Verfahren nach einem der Ansprüche 3 oder 4, **dadurch gekennzeichnet, dass**

- ein berechneter Wechselpunkt Tb für den Beginn des i-ten Linienabschnitts (28) in der nächsten Bildlinie (27), nach der Beziehung

$$Tb = [i \times K]_1 \qquad (i = 0, 1, 2, ....)$$

bestimmt wird, wobei das Produkt in der eckigen Klammer auf die nächste ganze Zahl gerundet wird,
- in einem Prüfbereich (30) um den berechneten Wechselpunkt Tb herum geprüft wird, ob in der aktuellen Bildlinie (27) und/oder in der nächsten Bildlinie (27) mindestens ein Farbsprung in den Bilddaten auftritt, und
- der aktuelle Wechselpunkt Ti, bei dem der nächste Linienabschnitt (28) in der nächsten Bildlinie (27) beginnt, an einer Stelle festgelegt wird, an der in den Bilddaten ein Farbsprung auftritt.

8. Verfahren nach Anspruch 7, **dadurch gekennzeichnet, dass** der aktuelle Wechselpunkt Ti bei dem Farbsprung festgelegt wird, der dem berechneten Wechselpunkt Tb am nächsten liegt.

9. Verfahren nach einem der Ansprüche 1 bis 8, **dadurch gekennzeichnet, dass** N Aufzeichnungslinien (25) mit einem Abstand 1/A parallel auf das Aufzeichnungsmaterial belichtet werden.

10. Verfahren nach einem der Ansprüche 1 bis 8, **dadurch gekennzeichnet, dass** N Aufzeichnungslinien (25) mit einem Abstand, der ein Vielfaches von 1/A ist, parallel auf das Aufzeichnungsmaterial belichtet werden.

Fig. 1

Fig. 3

Q

V

20

3

L

U

22

B

S1 S2 S3

15

Q

21

Fig. 2a

ZL

24

ZB

u

G1 G2 G3

v

23

Fig. 2b

Fig. 4

Fig. 5

Europäisches
Patentamt

European
Patent Office

Office européen
des brevets

**EUROPÄISCHER RECHERCHENBERICHT**

Nummer der Anmeldung

EP 10 16 1565

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 211 882 A (DAINIPPON SCREEN MFG [JP]) 5. Juni 2002 (2002-06-05) * Spalte 1, Absatz 1 - Spalte 2, Absatz 13; Abbildungen 19,20 * * Spalte 10, Absatz 65; Abbildungen 11,12 * ----- | 1-6,9,10 | INV. G06K15/12 B41J2/45 H04N1/06 B41B19/00 B41J19/16 |

RECHERCHIERTE
SACHGEBIETE (IPC)

H04N
B41J
B41B
G06K
G03F

Der vorliegende Recherchenbericht wurde für alle Patentansprüche erstellt

| Recherchenort | Abschlußdatum der Recherche | Prüfer |
|---|---|---|
| München | 15. Juni 2010 | Achermann, Didier |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
    ................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 10 16 1565

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-06-2010

| Im Recherchenbericht angeführtes Patentdokument | Datum der Veröffentlichung | Mitglied(er) der Patentfamilie | Datum der Veröffentlichung |
|---|---|---|---|
| EP 1211882 A | 05-06-2002 | JP 3416643 B2 <br> JP 2002166615 A <br> US 2002064317 A1 | 16-06-2003 <br> 11-06-2002 <br> 30-05-2002 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4591880 A
- EP 1318660 A2
- GB 2129650 A
- EP 0918255 A2